Europäisches Patentamt

European Patent Office

Office européen des brevets

(11) Veröffentlichungsnummer: **0 242 889**
**B1**

(12) **EUROPÄISCHE PATENTSCHRIFT**

(45) Veröffentlichungstag der Patentschrift: 03.10.90

(51) Int. Cl.⁵: **H 03 F 1/30**

(21) Anmeldenummer: 87200198.7

(22) Anmeldetag: 30.01.87

(54) Verfahren zur Kompensation der Offset-Spannung eines Regelverstärkers und Schaltungsanordnung zur Durchführung des Verfahrens.

(30) Priorität: 21.02.86 DE 3605561

(43) Veröffentlichungstag der Anmeldung:
28.10.87 Patentblatt 87/44

(45) Bekanntmachung des Hinweises auf die Patenterteilung:
03.10.90 Patentblatt 90/40

(84) Benannte Vertragsstaaten:
ES

(56) Entgegenhaltungen:
US-A-3 609 365
US-A-4 229 703
US-A-4 494 551

ELECTRONICS, Band 54, Nr. 16, August 1981, Seiten 109-112, New York, US; R. KASH:
"Building quality analog circuits with C-MOS logic arrays"
IDEM

(73) Patentinhaber: Deutsche Thomson-Brandt GmbH
Hermann-Schwer-Strasse 3 Postfach 1307
D-7730 Villingen-Schwenningen (DE)

(72) Erfinder: Kurz, Arthur
Wikingerstrasse 45
D-7516 Langensteinbach (DE)

Courier Press, Leamington Spa, England.

**Beschreibung** .

Die Erfindung betrifft ein Verfahren zur Kompensation der Offset-Spannung an einem Regelverstärker.

Regelverstärker werden z.B. in Fokus- und Trackregelkreisen bei optischen Abtastsystemen von CD-Plattenspielern eingesetzt. Bei CD-Plattenspielern werden die Nutzsignale, z.B. Ton- oder Videosignale, die auf einer CD-Platte in spiral- oder kreisförmigen Datenspuren gespeichert sind, mittels eines optischen Systems ausgelesen. Das optische System besteht in der Regel aus einer Linsenanordnung, deren Linsen mittels des Fokus-Regelkreises so in axialer Richtung verschoben werden, daß der Brennpunkt der Linsenanordnung auf der CD-Platte liegt. Man nennt diesen Regelvorgang, der im Prinzip der Scharfeinstellung eines Fernrohres entspricht, Fokussierung. Damit die Nutzsignale mittels des optischen Systems von der CD-Platte einwandfrei ausgelesen werden können, ist eine dauernde Fokussierung durch den Fokus-Regelkreis nötig. Weil bereits geringe Abweichungen von der Scharfeinstellung zu Fehlern beim Lesen der auf der CD-Platte abgespeicherten Nutzsignale führen, darf die Offset-Spannung des Regelverstärkers nicht zu groß werden. Sie muß deshalb kompensiert werden.

Aufgabe der Erfindung ist es daher, ein Verfahren zur Kompensation der Offset-Spannung eines Regelverstärkers anzugeben.

Die Erfindung löst diese Aufgabe dadurch, daß zum Messen der Offset-Kompensationsspannung der Ausgang des Regelverstärkers vom Stellglied des Regelkreises getrennt wird, daß der wert der Offset-Kompensationsspannung abgespeichert wird, daß nach dem Messen und Abspeichern der Offset-Kompensationsspannung der Ausgang des Regelverstärkers wieder mit dem Stellglied des Regelkreises verbunden wird und daß die abgespeicherte Offset-Kompensationsspannung an den Eingang des Regelverstärkers gelegt wird.

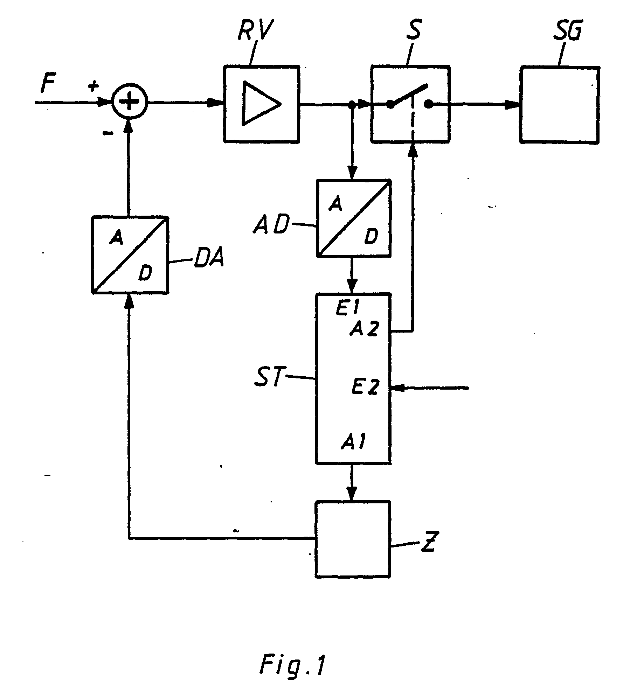

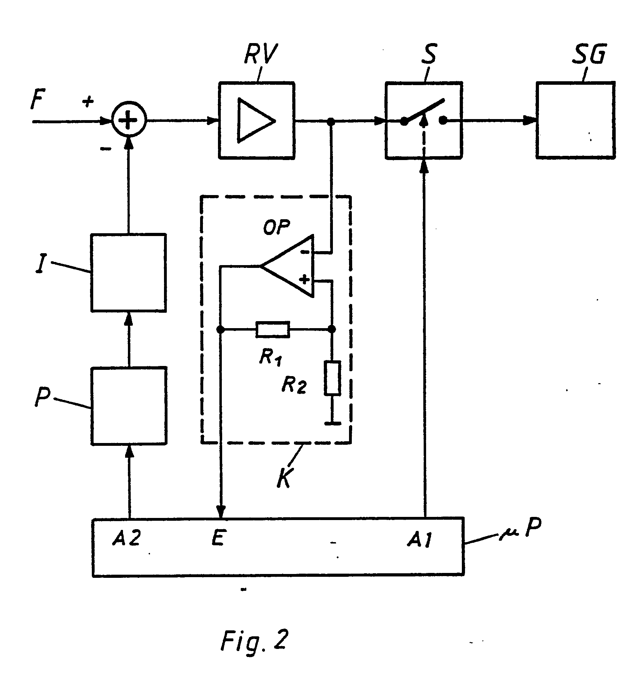

Die Figuren 1 und 2 zeigen Schaltungsanordnungen zur Durchführung des erfindungsgemäßen Verfahrens.

Anhand der in der Figur 1 gezeigten und in Anspruch 2 angegebenen Schaltungsanordnung wird das erfindungsgemäße Verfahren erläutert.

In der Figur 1 ist der Ausgang des Regelverstärkers RV mit dem Eingang eines Analog-Digital-Wandlers AD und mit dem einen Kontakt eines steuerbaren Schalters S verbunden, dessen anderer Kontakt mit dem Stellglied SG verbunden ist. Am Eingang des Regelverstärkers RV liegt das Stellsignal F für das Stellglied SG an. Der Ausgang des Analog-Digital-Wandlers AD ist mit einem ersten Eingang E1 einer Steuerschaltung ST verbunden. Ein erster Ausgang A1 der Steuerschaltung ST ist mit dem Eingang eines Vorwärts-Rückwärtszählers Z verbunden, dessen Ausgang mit dem Eingang eines Digital- Analog-Wandlers DA verbunden ist. Der Ausgang des Digital- Analog-Wandlers DA ist auf Eingang des Regelverstärkers RV rückgekoppelt. An einem zweiten Eingang E2 der Steuerschaltung ST liegt die Offset-Referenzspannung an. Ein zweiter Ausgang A2 der Steuerschaltung ST ist mit dem Steuereingang des steuerbaren Schalters S verbunden.

Es sei nun erklärt, wie die Schaltungsanordnung aus Figur 1, die z.B. in einem CD-Plattenspieler eingebaut sein kann, funktioniert.

Beim Einschalten des CD-Plattenspielers bewirkt die Steuerschaltung ST, daß der steuerbare Schalter S und dadurch auch der Fokus-Regelkreis geöffnet wird. Bei offenem Focus-Regelkreis wird die analoge Offset-Spannung am Ausgang des Regelverstärkers RV über den Analog-Digital-Wandler AD in digitaler Form der Steuerschaltung ST zugeführt, in der die Offset-Spannung mit der Offset-Referenzspannung — in der Regel O V — verglichen wird. Die Steuerschaltung ST gibt Zählimpulse an den Vorwärts-Rückwärtszähler Z ab, wenn die Offset-Spannung am Ausgang des Regelverstärkers RV nicht mit der Offset-Referenzspannung von O V übereinstimmt. Der Zahlenwert an Ausgang des Zählers Z wird im Digital-Analog-Wandler DA in eine analoge Spannung ungesetzt, die auf den Eingang des Regelverstärkers RV rückgekoppelt wird und die Offset-Spannung kompensiert, weil der Vorwärts-Rückwärtszähler Z von der Steuerschaltung ST so lange Zählimpulse erhält, bis die Offset-Spannung zu null wird. Ist die Offset-Spannung am Ausgang des Regelverstärkers RV kompensiert, dann schließt die Steuerschaltung ST den steuerbaren Schalter S, damit der Fokus-Regelkreis wieder geschlossen wird und damit der Brennpunkt der Linsenanordnung auf der Platte zu liegen kommt. Außerdem gibt die Steuerschaltung ST von diesem Zeitpunkt an keine weiteren Zählimpulse an den Vorwärts-Rückwärtszähler Z mehr ab, so daß in ihm der Wert der Kompensationsspannung abgespeichert ist. Über den Digital-Analog-Wandler DA liegt diese Kompensationsspannung dauernd am Eingang des Regelverstärkers RV in analoger Form an. Wenn der CD-Plattenspieler ausgeschaltet und wieder neu eingeschaltet wird, wird erneut, wie eben beschrieben, der steuerbare Schalter S geöffnet, die Kompensationsspannung ermittelt, abgespeichert und in analoger Form an den Eingang des Regelverstärkers RV gelegt.

In der Figur 2 ist eine weitere Schaltungsanordnung zur Durchführung des erfindungsgemäßen Verfahrens gezeigt.

An Eingang des Regelverstärkers RV liegt das Stellsignal F für das Stellglied SG an. Der Ausgang des Regelverstärkers RV ist mit dem invertierenden Eingang eines Operationsverstärkers OP und mit dem einen Kontakt eines steuerbaren Schalters S verbunden, dessen anderer Kontakt mit dem Eingang des Stellgliedes SG verbunden ist. Der Ausgang des Operationsverstärkers OP ist mit dem Eingang E eines Mikroprozessors µP und über einen ersten Widerstand R1 mit seinem nichtinvertierenden Eingang verbunden, der über einen zweiten Widerstand R2 auf Bezugspotential liegt. Ein erster Ausgang A1 des Mikroprozessors

µP ist mit dem Steuereingang des steuerbaren Schalters S verbunden. Ein zweiter Ausgang A2 des Mikroprozessor µP ist mit dem Eingang eines Pulsbreitenmodulators P verbunden, dessen Ausgang mit dem Eingang eines Integrators I verbunden ist. Der Ausgang des Integrators I ist mit dem Eingang des Regelverstärkers RV verbunden.

Im folgenden wird die Funktion der Schaltungsanordnung aus Figur 2 erklärt.

Wie bei der Schaltungsanordnung aus Figur 1 wird beim Einschalten des Gerätes der Fokus-Regelkreis dadurch geöffnet, daß der Mikroprozessor µP den steuerbaren Schalter S durch ein Signal, das er an seinem ersten Ausgang A1 abgibt, öffnet. Der Operationsverstärker OP bildet zusammen mit dem ersten und dem zweiten Widerstand R1 und R2 einen Komparator K, in dem die Offset-Spannung mit der Offset-Referenzspannung verglichen wird. Der Mikroprozessor µP ändert die Spannung an seinem zweiten Ausgang A2 so lange, bis die Offset-Spannung am Ausgang des Regelverstärkers RV mit der Offset-Referenzspannung übereinstimmt, d.h. bis die Offset-Spannung kompensiert ist. Im Mikroprozessor µP wird nun der Wert der Spannung gespeichert, der die Offset-Spannung am Ausgang des Regelverstärkers RV kompensiert. Außerdem gibt der Mikroprozessor µP an seinem ersten Ausgang A1 ein Signal ab, das den steuerbaren Schalter S und damit auch den Fokus-Regelkreis wieder schließt. Über den Pulsbreitenmodulator P und den Integrator I liegt jetzt dauernd die Kompensationsspannung am Eingang des Regelverstärkers RV an. Bei jedem Wiedereinschalten des Gerätes wird wie bei der in Figur 1 gezeigten Schaltungsanordnung die Offset-Spannung erneut kompensiert.

Der Pulsbreitenmodulator P kann im Mikroprozessor µP integriert oder durch Software im Mikroprozessor µP realisiert sein.

Ein Vorteil der Erfindung besteht darin, daß bei der Herstellung von CD-Plattenspielern, deren Fokus-Regelkreis nach dem erfindungsgemäßen Verfahren arbeitet, kein Abgleich der Regelverstärker mehr erforderlich ist. Weil jedesmal, wenn das Gerät eingeschaltet wird, die Offset-Spannung von neuem kompensiert wird, wirken sich langfristige Driften der Offset-Spannung infolge Alterung der Bauelemente nicht aus. Es kann deshalb nicht der Fall eintreten, daß der Regelverstärker des Fokus-Regelkreises in einem CD-Plattenspieler, der zunächst einwandfrei spielte, bei dem aber nach längerer Zeit die Klangqualität spürbar nachließ, in der Werkstatt neu abgeglichen werden muß. Daß solche Wartungsmaßnahmen bei Geräten entfallen, deren Regelkreise nach dem erfindungsgemäßen Verfahren arbeiten, ist als weiterer Vorteil zu betrachten, denn die Wartung eines Gerätes ist nicht nur für den Kunden unangenehm, sie kostet auch Geld.

**Patentansprüche**

1. Verfahren zur Kompensation der Offset-Spannung eines Regelverstärkers (RV), dadurch gekennzeichnet, daß zum Messen der Offset-Kompensationsspannung der Ausgang des Regelverstärkers (RV) vom Stellglied (SG) des Regelkreises getrennt wird, daß der Wert der Offset-Kompensationsspannung abgespeichert wird, daß nach dem Messen und Abspeichern der Offset-Kompensationsspannung der Ausgang des Regelverstärkers (RV) wieder mit dem Stellglied (SG) des Regelkreises verbunden wird und daß die abgespeicherte Offset-Kompensationsspannung auf den Eingang des Regelverstärkers (RV) rückgekoppelt wird.

2. Schaltungsanordnung zur Durchführung des Verfahrens nach Anspruch 1, dadurch gekennzeichnet, daß am Eingang des Regelverstärkers (RV) das Stellsignal (F) für das Stellglied (SG) anliegt, daß der Ausgang des Regelverstärkers (RV) mit dem Eingang eines Analog-Digital-Wandlers (AD) und mit dem einen Kontakt eines steuerbaren Schalters (S) verbunden ist, dessen anderer Kontakt mit dem Stellglied (SG) verbunden ist, daß der Ausgang des Analog-Digital-Wandlers (AD) mit einem ersten Eingang (E1) einer Steuerschaltung (ST) verbunden ist, daß ein erster Ausgang (A1) der Steuerschaltung (ST) mit dem Eingang eines Vorwärts-Rückwärtszählers (Z) verbunden ist, daß der Ausgang des Vorwärts-Rückwärtszählers (Z) mit dem Eingang eines Digital-Analog-Wandlers (DA) verbunden ist, dessen Ausgang mit dem Eingang des Regelverstärkers (RV) verbunden ist, daß an einem zweiten Eingang (E2) der Steuerschaltung (ST) die Offset-Referenzspannung anliegt und daß ein zweiter Ausgang (A2) der Steuerschaltung (ST) mit dem Steuereingang des steuerbaren Schalters (S) verbunden ist.

3. Schaltungsanordnung nach Anspruch 2, dadurch, gekennzeichnet, daß der Digital-Analog-Wandler (DA) als Reihenschaltung aus einem Pulsmodulator (P) und einem Integrator (I) aufgebaut ist.

4. Schaltungsanordnung zur Durchführung des Verfahrens nach Anspruch 1, dadurch gekennzeichnet, daß am Eingang des Regelverstärkers (RV) das Stellsignal (F) für das Stellglied (SG) anliegt, daß der Ausgang des Regelverstärkers (RV) mit dem invertierenden Eingang eines Operationsverstärkers (OP) und mit dem einen Kontakt eines steuerbaren Schalters (S) verbunden ist, dessen anderer Kontakt mit dem Eingang des Stellgliedes (SG) verbunden ist, daß der Ausgang des Operationsverstärkers (OP) mit einem Eingang (E) eines Mikroprozessors (µP) und über einen ersten Widerstand (R1) mit seinem nichtinvertierenden Eingang verbunden ist, daß der nichtinvertierende Eingang des Operationsverstärkers (OP) über einen zweiten Widerstand (R2) auf Bezugspotential liegt, daß ein erster Ausgang (A1) des Mikroprozessors (µP) mit dem Steuereingang des steuerbaren Schalters (S) verbunden ist daß ein zweiter Ausgang (A2) des Mikroprozessors (µP) mit dem Eingang eines Pulsmodulators (P) verbunden ist, dessen Ausgang mit dem Eingang eines Integrators (I) verbunden ist, und daß der Ausgang des Integrators (I) mit dem Eingang des Regelverstärkers (RV) verbunden ist.

5. Schaltungsanordnung nach Anspruch 3 oder 4, dadurch gekennzeichnet, daß der Pulsmodulator (P) ein Pulsbreitenmodulator ist.

6. Schaltungsanordnung nach Anspruch 4 oder 5, dadurch gekennzeichnet, daß der Pulsmodulator (P) im Mikroprozessor (μP) integriert ist.

7. Schaltungsanordnung nach Anspruch 4 oder 5, dadurch gekennzeichnet, daß der Pulsmodulator (P) durch Software im Mikroprozessor (μP) realisiert ist.

## Revendications

1. Procédé de compensation de la tension offset d'un amplificateur de régulation (RV), caractérisé en ce que la sortie de l'amplificateur de régulation (RV) est séparée de l'organe de commande (SG) du circuit de régulation pour mesurer la tension offset de compensation, que la valeur de la tension offset de compensation est mise en mémoire, que la sortie de l'amplificateur de régulation (RV) est de nouveau reliée à l'organe de commande (SG) du circuit de régulation après la mesure et la mise en mémoire de la tension offset de compensation et que la tension offset de compensation est appliquée en contreréaction à l'entrée de l'amplificateur de régulation (RV).

2. Montage pour la mise en oeuvre du procédé selon la revendication 1, caractérisé en ce que le signal de commande (F) pour l'organe de commande (SG) apparaît à l'entrée de l'amplificateur de régulation (RV), que la sortie de l'amplificateur de régulation (RV) est reliée à l'entrée d'un convertisseur analogique/numérique (AD) et à l'un des contacts d'un commutateur (S) susceptible d'être commandé, dont l'autre contact est relié à l'organe de commande (SG), que la sortie du convertisseur analogique/numérique (AD) est reliée à une première entrée (E1) d'un circuit de commande (ST), qu'une première sortie (A1) du circuit de commande (ST) est reliée à l'entrée d'un compteur/décompteur (Z), que la sortie du compteur/décompteur est reliée à l'entrée d'un convertisseur numérique/analogique (DA) dont la sortie est reliée à l'entrée de l'amplificateur de régulation (RV), que la tension offset de référence est appliquée à une deuxième entrée (E2) du circuit de commande (ST) et qu'une deuxième sortie (A2) du circuit de commande (ST) est reliée à l'entrée de commande du commutateur (S).

3. Montage selon la revendication 2, caractérisé en ce que le convertisseur numérique/analogique (DA) est un circuit monté en série formé par un modulateur d'impulsions (P) et un intégrateur (1).

4. Montage pour la mise en oeuvre du procédé selon la revendication 1, caractérisé en ce que le signal de commande (F) pour l'organe de commande (SG) est appliqué à l'entrée de l'amplificateur de régulation (RV), que la sortie de l'amplificateur de régulation (RV) est reliée à l'entrée inverseuse d'un amplificateur opérationnel (OP) et à l'un des contacts d'un commutateur (S) dont l'autre contact est relié à l'entrée de l'organe de commande (SG), que la sortie de l'amplificateur opérationnel (OP) est relié à une entrée (E) d'un microprocesseur (μP) et à son entrée non inverseuse par une première résistance (R1), que l'entrée non inverseuse de l'amplificateur opérationnel (OP) reçoit un potentiel de référence par une deuxième résistance (R2), qu'une première sortie (A1) du microprocesseur (μP) est reliée à l'entrée de commande du commutateur (S), qu'une deuxième sortie (A2) du microprocesseur (μP) est reliée à l'entrée d'un modulateur en largeur d'impulsions (P) dont la sortie est reliée à l'entrée d'un intégrateur (I), et que la sortie de l'intégrateur (I) est reliée à l'entrée de l'amplificateur de régulation (RV).

5. Montage selon la revendication 3 ou 4, caractérisé en ce que le modulateur d'impulsions (P) est un modulateur en largeur d'impulsions.

6. Montage selon la revendication 4 ou 5, caractérisé en ce que le modulateur d'impulsions (P) est intégré dans le microprocesseur (μP).

7. Montage selon la revendication 4 ou 5, caractérisé en ce que modulateur d'impulsions (P) est réalisé par un programme logé dans le microprocesseur (μP).

## Claims

1. Process for compensation of the offset-voltage of a control-amplifier (RV), characterized in that the output of the control-amplifier (RV) is separated from the regulating unit (SG) of the control circuit for measuring the offset-compensation voltage, that the value of the offset-compensation voltage is stored, that after measuring and storing of the offset-compensation voltage the output of the control amplifier (RV) is again connected with the regulating unit (SG) of the control circuit and that the stored offset-compensation voltage is fed back to the input of the control amplifier (RV).

2. Circuit arrangement for the realisation of the process according to claim 1, characterized in that the regulating signal (F) for the regulating unit (SG) is applied to the input of the control amplifier (RV), that the output of the control amplifier (RV) is connected to the input of an analog-digital converter (AD) and to the one contact of a controllable switch (S), whose other contact is connected with the regulating unit (SG), that the output of the analog-digital converter (AD) is connected with a first input (E1) of a control circuit (ST), that a first output (A1) of the control circuit (ST) is connected with the input of a forward-backward counter (Z), that the output of the forward-backward counter (Z) is connected with the input of a digital-analog converter (DA), whose output is connected with the input of the control amplifier (RV), that at a second input (E2) of the control circuit (ST) is applied the offset-reference voltage and that a second output (A2) of the control circuit (ST) is connected with the control input of the controllable switch (S).

3. Circuit arrangement according to claim 2, characterized in that the digital-analog converter (DA) is constructed of a series circuit of a pulsmodulator (P) and an integrator (I).

4. Circuit arrangement for the realisation of the process according to claim 1, characterized in that the regulating signal (F) for the regulating unit (SG) is applied to the input of the control amplifier (RV), that the output of the control amplifier (RV) is connected with the inverting input of an operational amplifier (OP) and with the one contact of a controllable switch (S), whose other contact is connected with the input of the regulating unit (SG), that the output of the operational amplifier (OP) is connected with an input of a microprocessor (µP) and via a first resistor (R1) with its not-inverting input, that the not-inverting input of the operational amplifier (OP) is applied to reference potential via a second resistor (R2), that a first output (A1) of the microprocessor (µP), is connected with the control input of the controllable switch (S), that a second output (A2) of the microprocessor (µP) is connected with the input of a pulsmodulator (P), whose output is connected with the input of an integrator (I), and that the output of the integrator (I) is connected with the input of the control amplifier (RV).

5. Circuit arrangement according to claims 3 or 4, characterized in that the pulsmodulator (P) is a puls-width-modulator.

6. Circuit arrangement according to claims 4 or 5, characterized in that the pulsmodulator (P) is integrated in the microprocessor (µP).

7. Circuit arrangement according to claims 4 or 5, characterized in that the pulsmodulator (P) is realized by software in the microprocessor (µP).

*Fig.1*

Fig. 2